# EUROPÄISCHE PATENTANMELDUNG

(11) **EP 2 305 746 A1**
(43) Veröffentlichungstag der Anmeldung: **06.04.2011**
(21) Anmeldenummer: 09172034.2
(22) Anmeldetag: 02.10.2009
(51) Int. Cl.: C08J 9/04, H01L 31/048

(54) **Membran umfassend Solarzelle**

(71) Anmelder: Sika Technology AG, 6340 Baar (CH)
(72) Erfinder: Keiser, Stefan, 6103 Schwarzenberg (CH); Michel, Adrian, 6375 Beckenried (CH); Blank, Norman, 8803 Rüschlikon (CH); Lussi, Josef, 3920 Zermatt (CH); Meier, Heinz, 8032 Zürich (CH)
(74) Vertreter: Isler, Jörg

(57) **Zusammenfassung**

Bei einer Membran umfassend eine Schottschicht, eine Solarzelle, angeordnet an einer Seite der Schottschicht, sowie eine Ausgleichsschicht, angeordnet zwischen Solarzelle und Schottschicht, handelt es sich bei der Ausgleichsschicht um eine geschäumte Zusammensetzung aus einem bei Raumtemperatur festen Thermoplast oder einem bei Raumtemperatur festen thermoplastischen Elastomer.

## Beschreibung

### Technisches Gebiet

Die Erfindung betrifft das Gebiet der Photovoltaikelemente, insbesondere zur Aufbringung auf Dächern.

### Stand der Technik

Das Aufbringen von Solarzellen auf Dachbahnen über Klebstoffe ist bekannt. Der Nachteil dieser Art von Befestigung ist jedoch, dass sich die Solarzellen, insbesondere aufgrund von mechanischen Spannungen, von Dachbahnen lösen und sich dazwischen Hohlräume bilden können. Das nachfolgende Eindringen von Feuchtigkeit in diese Hohlräume wirkt sich besonders nachteilig auf den Verbund, insbesondere durch Schädigung der Klebstoffe, von Solarzelle und Dachbahn aus und fördert das weitere Ablösen.

Erwähnte Spannungen sind insbesondere bedingt durch horizontales und vertikales Verschieben gegeneinander von Solarzelle und Dachbahn, insbesondere wegen unterschiedlicher thermischer Längenausdehnungskoeffizienten der beiden Schichten. Solche Spannungen treten insbesondere bei Erwärmung durch intensive Sonneneinstrahlung oder bei tiefen Aussentemperaturen auf.

### Darstellung der Erfindung

Aufgabe der vorliegenden Erfindung ist es daher, eine Membran der eingangs genannten Art dahingehend zu verbessern, das Ablösen von auf Dachbahnen aufgebrachten Solarzellen und infolgedessen das Ausbilden von Hohlräumen und das anschliessende Eindringen von Feuchtigkeit zu minimieren.

Erfindungsgemäss wird dies durch die Merkmale des ersten Anspruches erreicht.

Kern der Erfindung ist es also, dass bei einer Membran umfassend eine Schottschicht und eine Solarzelle, angeordnet an einer Seite der Schottschicht, eine Ausgleichsschicht zwischen Solarzelle und Schottschicht angeordnet ist. Bei dieser Ausgleichsschicht handelt es sich um eine geschäumte Zusammensetzung aus einem bei Raumtemperatur festen Thermoplast oder einem bei Raumtemperatur festen thermoplastischen Elastomer.

Es ist besonders zweckmässig, wenn es sich bei der geschäumten Zusammensetzung um eine geschlossenporige Zusammensetzung handelt, wodurch keine Feuchtigkeit durch die Ausgleichsschicht zwischen Schottschicht und Solarzelle eindringen kann.

Es ist besonders zweckmässig, wenn als Ausgleichsschicht Materialien verwendet werden, welche mechanische Spannungen durch horizontales und vertikales Verschieben gegeneinander von Solarzelle und Schottschicht, insbesondere bedingt durch unterschiedliche thermische Längenausdehnungskoeffizienten der beiden Schichten, auszugleichen vermögen.

Weitere vorteilhafte Ausgestaltungen der Erfindung ergeben sich aus den Unteransprüchen.

Weitere Aspekte der Erfindung sind Gegenstand weiterer unabhängiger Ansprüche.

### Kurze Beschreibung der Zeichnung

Im Folgenden werden anhand der Zeichnungen Ausführungsbeispiele der Erfindung näher erläutert. Gleiche Elemente sind in den verschiedenen Figuren mit den gleichen Bezugszeichen versehen.

Es zeigen:
Fig. 1 einen Querschnitt durch eine erfindungsgemässe Membran,
Fig. 2 einen weiteren Querschnitt durch eine erfindungsgemässe Membran,
Fig. 3 einen weiteren Querschnitt durch eine erfindungsgemässe Membran,
Fig. 4 mögliche seitliche Abdichtungen anhand von Querschnitten durch eine erfindungsgemässe Membran.

Es sind nur die für das unmittelbare Verständnis der Erfindung wesentlichen Elemente gezeigt.

### Weg zur Ausführung der Erfindung

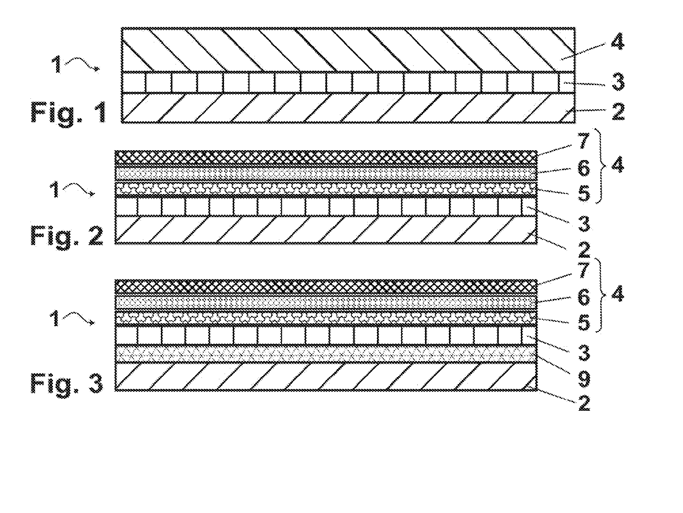

In der Figur 1 ist eine Membran 1 dargestellt, umfassend eine Schottschicht 2, eine Solarzelle 4, angeordnet an einer Seite der Schottschicht, sowie ein Ausgleichsschicht 3, angeordnet zwischen Solarzelle und Schottschicht, wobei es sich bei der Ausgleichsschicht um eine geschäumte Zusammensetzung aus einem bei Raumtemperatur festen Thermoplast oder einem bei Raumtemperatur festen thermoplastischen Elastomer handelt.

Unter "geschäumter Zusammensetzung" wird im vorliegenden Dokument ein Gebilde aus kugel- oder polyederförmigen Poren verstanden, welche durch Stege begrenzt werden und ein zusammenhängendes System bilden.

Unter Poren werden im vorliegenden Dokument durch die Herstellung bedingte Hohlräume in und/oder auf der Oberfläche einer Zusammensetzung verstanden, die mit Luft oder anderen zusammensetzungsfremden Stoffen ausgefüllt sind. Die Poren können von blossem Auge erkennbar oder nicht erkennbar sein. Es kann sich um offene Poren, welche mit dem umgebenden Medium in Verbindung stehen, oder um geschlossene Poren, welche in sich abgeschlossen sind und kein Medium eindringen lassen, handeln. Weiter kann auch eine Mischform aus offenen und geschlossenen Poren vorliegen.

Eine geschlossenporige Ausgleichsschicht ist dahingehend von Vorteil, dass keine Feuchtigkeit durch die Ausgleichsschicht 3 zwischen Schottschicht 2 und Solarzelle 4 eindringen kann.

Es ist weiter von Vorteil, dass die geschäumte Zusammensetzung eine Porengrösse von 0.1 - 3 mm, insbesondere 0.2 - 1 mm und/oder ein Porenvolumen von 5 - 99%, insbesondere 30 - 98%, aufweist. Unter Porenvolumen wird im vorliegenden Dokument der Anteil in Prozent der Gesamtheit der mit Luft oder anderen zusammensetzungsfremden Stoffen ausgefüllten Hohlräume am Volumen der geschäumten Zusammensetzung verstanden.

Geschlossenporige geschäumte Zusammensetzungen, insbesondere mit einer Porengrösse kleiner als 1 mm, sind aufgrund ihrer höheren mechanischen Stabilität bevorzugt.

Als Ausgleichsschicht 3 sind weiter Materialien vorteilhaft, welche Spannungen durch horizontales und vertikales Verschieben gegeneinander von Solarzelle und Schottschicht, insbesondere bedingt durch unterschiedliche thermische Längenausdehnungskoeffizienten der beiden Schichten, auszugleichen vermögen.

Solche mechanischen Spannungen treten besonders durch Erwärmen der Membran, insbesondere der Solarzelle, bei intensiver Sonneneinstrahlung auf oder bei tiefen Aussentemperaturen. Eine Entkopplung solcher Spannungen ist dahingehend von Vorteil, dass ein Ablösen von Solarzelle 4 von der Schottschicht 2 und ein Eindringen von Feuchtigkeit in den Zwischenraum verhindert wird. Das Eindringen von Flüssigkeit wirkt sich besonders nachteilig auf den Verbund von Solarzelle und Schottschicht aus und fördert das weitere Ablösen. Weiter kann es zu Korrosion der Leiterbahnen kommen.

Gegenüber dem direkten Verbund von Solarzelle 4 mit der Schottschicht 2 mittels herkömmlichen Klebstoffen lassen sich durch geschäumte Zusammensetzungen eine höhere Schichtdicke des Verbunds von Solarzelle und Schottschicht erreichen, was sich positiv auf die Entkopplung von Spannungen auswirkt, weiter neigen geschäumte Zusammensetzungen unter erhöhter Temperatur nur sehr beschränkt zum Kriechen. Die geringe Kriechneigung ist beispielsweise bedingt durch den einstellbaren Vernetzungsgrad und unterschiedliches Molekulargewicht, und geschäumte Zusammensetzungen behalten ihre Geometrie länger bei. Weiter können gewisse geschäumte Zusammensetzungen leicht durch Erhitzen, beispielsweise Schweissen oder Kalandrieren, mit der Schottschicht oder der Solarzelle verbunden werden. Weiter können geschäumte Zusammensetzungen aufgrund ihrer porösen Struktur besser Zug- und Scherkräfte aushalten.

Vorzugsweise weist die Ausgleichsschicht 3 eine Dichte von 0.02 - 1.2 g/cm³, bevorzugt 0.03 - 0.8 g/cm³, insbesondere bevorzugt 0.05 - 0.5 g/cm³ auf.

Eine tiefere Dichte der geschäumten Zusammensetzung ist dahingehend von Vorteil, dass weniger Wärmeenergie zum Verschweissen der geschäumten Zusammensetzung nötig ist.

Es ist weiter von Vorteil, wenn die Ausgleichsschicht 3 einen hohen elektrischen Isolationswiderstand aufweist. Weiter von Vorteil sind gute thermische Isolationseigenschaften.

Bei der Ausgleichsschicht 3 handelt es sich um eine geschäumte Zusammensetzung aus einem bei Raumtemperatur festen Thermoplast oder einem bei Raumtemperatur festen thermoplastischen Elastomer.

Unter dem Begriff "Raumtemperatur" wird im vorliegenden Dokument eine Temperatur von 23°C verstanden. Thermoplastische Elastomere haben den Vorteil, dass die Ausgleichsschicht dadurch über eine gute Elastizität gegenüber Horizontal- und Vertikalverschiebungen, insbesondere bei Verschiebungen der Solarzelle gegenüber der Schottschicht, verfügt. Eine gute Elastizität der Ausgleichsschicht verhindert ein Reissen oder Ablösen und somit ein Versagen der Ausgleichsschicht. Idealerweise weist die Ausgleichsschicht eine Reissfestigkeit σ_{B} von 0.1 - 10 MPa bei Raumtemperatur auf und/oder eine Reissdehnung ε_{R} von 5 - 1000 %, beide gemessen nach DIN ISO 527.

Als thermoplastische Elastomere werden in diesem Dokument Kunststoffe verstanden, welche die mechanischen Eigenschaften von vulkanisierten Elastomeren mit der Verarbeitbarkeit von Thermoplasten vereinen. Typischerweise sind derartige thermoplastische Elastomere Block-Copolymere mit Hart- und Weichsegmenten oder so genannte Polymerlegierungen mit entsprechend thermoplastischen und elastomeren Bestandteilen.

Bevorzugte Thermoplaste und thermoplastische Elastomere sind insbesondere ausgewählt aus der Gruppe bestehend aus Polyethylen (PE), Polyethylen mit tiefer Dichte (LDPE), Ethylen/Vinylacetat-Copolymer (EVA), Polybuten (PB); thermoplastische Elastomere auf Olefinbasis (TPE-O, TPO) wie Ethylen-Propylen-Dien/Polypropylen-Copolymere; vernetzte thermoplastische Elastomere auf Olefinbasis (TPE-V, TPV); thermoplastische Polyurethane (TPE-U, TPU) wie TPU mit aromatischen Hartsegmenten und Polyester-Weichsegmenten (TPU-ARES), Polyether-Weichsegmenten (TPU-ARET), Polyester- und Polyether-Weichsegmenten (TPU-AREE) oder Polycarbonat-Weichsegmenten (TPU-ARCE); thermoplastische Copolyester (TPE-E, TPC) wie TPC mit Polyester-Weichsegmenten (TPC-ES), Polyether-Weichsegmenten (TPC-ET) oder mit Polyester- und Polyether-Weichsegmenten (TPC-EE); Styrol-Block-Copolymere (TPE-S, TPS) wie Styrol/Butadien-Block-Copolymer (TPS-SBS), Styrol/Isopren-Block-Copolymer (TPS-SIS), Styrol/Ethylen-Butylen/Styrol-Block-Copolymer (TPS-SEBS), Styrol/Ethylen-Propylen/Styrol-Block-Copolymer (TPS-SEPS); und thermoplastische Copolyamide (TPE-A, TPA).

Vorzugsweise handelt es sich bei der Ausgleichsschicht 3 um eine geschäumte Zusammensetzung aus einem Material, welches ausgewählt ist aus der Gruppe bestehend aus Acrylatverbindungen, Acrylatcopolymeren, Polyurethanpolymeren, Silan-terminierten Polymeren und Polyolefinen, insbesondere aus Polyolefinen.

Besonders bevorzugt als Polyolefin ist Polyethylen (PE).

Vorzugsweise handelt es sich bei der Ausgleichsschicht 3 um eine geschäumte Zusammensetzung mit einer geringen Feuchtigkeitsaufnahme, welche sich zusätzlich gut mit der Schottschicht verbinden lässt.

Die Ausgleichsschicht 3 kann direkt mit der Schottschicht 2 verbunden sein. Unter "direkt verbunden" wird verstanden, dass keine weitere Schicht oder Substanz zwischen zwei Werkstoffen vorliegt und dass die zwei Werkstoffe direkt miteinander verbunden sind, beziehungsweise aneinander haften. Dies ist beispielsweise in Figur 1 und Figur 2 gezeigt. Am Übergang zwischen zwei Werkstoffen können die zwei Werkstoffe ineinander vermischt vorliegen.

Die Ausgleichsschicht 3 kann im Wesentlichen fest an der Schottschicht 2 angeordnet sein. Dies kann insbesondere dadurch erfolgt sein, dass bei der Herstellung der Membran die Ausgleichsschicht und die Schottschicht durch Wärmeeinwirkung, durch Druck, durch physikalische Absorption oder durch jede andere physikalische Krafteinwirkung direkt miteinander verbunden werden. Dies hat insbesondere den Vorteil, dass keine chemische Verbindung von Schottschicht und Ausgleichsschicht mittels Klebstoffen notwendig ist, was sich vorteilhaft auf die Herstellungskosten der Membran 1 auswirkt. Insbesondere können Schottschicht und Ausgleichsschicht durch Kaschieren miteinander verbunden werden. Durch Kaschieren kann ein starker Verbund zwischen Ausgleichsschicht und Schottschicht erreicht werden, insbesondere wenn beide aus PE bestehen oder aus untereinander verträglichen Materialien. Zusätzlich ist die Verbundsqualität bei der Herstellung von Membranen beim Kaschieren zuverlässiger und weniger Schwankungen bei den Produktionsparametern unterworfen als bei dem Verbund durch Klebstoffe.

Es besteht jedoch auch die Möglichkeit, Ausgleichsschicht und Schottschicht durch eine Klebschicht 9 miteinander zu verbinden, wie dies beispielsweise in Figur 3 gezeigt ist. Dies ist insbesondere dann vorteilhaft, wenn sich aufgrund der Materialen eine Kaschierung der Ausgleichsschicht mit der Schottschicht nicht anbietet.

Ein in einer solchen Klebschicht 9 verwendeter Klebstoff kann beispielsweise ein Haftklebstoff und/oder ein Schmelzklebstoff sein. Dies gewährleistet einen guten Verbund und eine gute Haftung der Ausgleichsschicht 3 auf der Schottschicht 2 und vermindert somit das Ablösen des Ausgleichsschicht und somit ein Versagen der Ausgleichsschicht. Der Klebstoff kann auch eine Barrierewirkung gegen Diffusion und Migration von Inhaltsstoffen der Membrane bewirken

Haftklebstoffe und Schmelzklebstoff sind dem Fachmann allgemein bekannt und sind beschrieben in CD Römpp Chemie Lexikon, Version 1.0, Georg Thieme Verlag, Stuttgart.

Vorzugsweise handelt es sich bei einem solchen Klebstoff um Klebstoffe ausgewählt aus der Gruppe bestehend aus Ethylen/Vinylacetat-Copolymer (EVA), vernetzbare thermoplastische Elastomere auf Olefinbasis, Acrylatverbindungen, Polyurethanpolymeren und Silan-terminierten Polymeren.

Bevorzugte Acrylatverbindungen sind insbesondere Acrylatverbindungen auf Basis von Acryl-Monomeren, insbesondere von Acryl- und Methacrylsäureestern.

Der Begriff "Polyurethanpolymer" umfasst sämtliche Polymere, welche nach dem so genannten Diisocyanat-Polyadditions-Verfahren hergestellt werden. Dies schliesst auch solche Polymere ein, die nahezu oder gänzlich frei sind von Urethangruppen. Beispiele für Polyurethanpolymere sind Polyether-Polyurethane, Polyester-Polyurethane, Polyether-Polyharnstoffe, Polyharnstoffe, Polyester-Polyharnstoffe, Polyisocyanurate und Polycarbodiimide.

Bevorzugte Klebstoffe sind unter dem Namen SikaLastomer®-68 bei Sika Corporation, USA kommerziell erhältlich.

Durch Oberflächenbehandlungen wie beispielsweise Coronabehandlung, Fluorierung, Plasmabehandlung und Beflammung der Ausgleichsschicht 3 und/oder der Schottschicht 2 kann die Haftung der Ausgleichsschicht oder eines möglichen Klebstoffs auf der Ausgleichsschicht und/oder der Schottschicht verbessert werden.

Eine flexible Membran 1 erlaubt ein Aufrollen, was deren Lagerung, Transport und das Anbringen auf einem Untergrund erleichtert.

Die Schottschicht 2 kann aus allen Materialien bestehen, welche auch bei hohen Flüssigkeitsdrücken eine ausreichende Dichtheit gewährleisten.

Es ist also von Vorteil, wenn die Schottschicht 2 eine hohe Beständigkeit gegen Wasserdruck und Witterung aufweist, sowie gute Werte in Weiterreissversuchen und Perforationsversuchen zeigt, was besonders bei mechanischen Belastungen auf Baustellen von Vorteil ist. Weiter ist eine Beständigkeit gegenüber andauernden mechanischen Belastungen, beispielsweise Wind, vorteilhaft.

Die Schottschicht kann aus einem starren Material bestehen, wie beispielsweise Aluminium, Stahl, Kunststoffüberzogenes Blech, Kunststoffplatten oder andererseits flexibel sein. Vorzugsweise handelt es sich um ein flexibles Material.

Es ist insbesondere von Vorteil, wenn die Schottschicht 2 eine Thermoplastschicht, vorzugsweise eine Schicht aus thermoplastischen Polyolefinen oder Polyvinylchlorid (PVC), insbesondere eine Schicht aus Polypropylen (PP) oder Polyethylen (PE), insbesondere bevorzugt aus Polypropylen, aufweist. Daraus resultiert eine hohe Widerstandsfähigkeit gegenüber Umwelteinflüssen.

Vorzugsweise ist die Schottschicht 2 ausgewählt aus Materialien aus der Gruppe bestehend aus Polyethylen mit hoher Dichte (HDPE), Polyethylen mit mittlerer Dichte (MDPE), Polyethylen mit tiefer Dichte (LDPE), Polyethylen (PE), Polyvinylchlorid (PVC), Ethylen/Vinylacetat-Copolymer (EVA), chlorsulfoniertes Polyethylen, thermoplastische Elastomere auf Olefinbasis (TPE-O, TPO), Ethylen-Propylen-Dien-Kautschuk (EPDM) und Polyisobutylen (PIB), sowie und Mischungen davon.

Die Schottschicht 2 kann eine Dicke von 0.05 - 3 mm, bevorzugt 0.08 - 2.5 mm, insbesondere 1 - 2 mm, aufweisen.

Die Solarzelle 4 besteht typischerweise aus einer Trägerschicht 5, einer Fotovoltaikschicht 6 und eventuell einer Deckschicht 7, wie dies beispielsweise in den Figuren 2 und 3 dargestellt ist.

Bei der Deckschicht 7 handelt es sich vorzugsweise um Kunststoffe, welche sich über eine geringe UV-Absorbtion auszeichnen. Geeignete Materialien für die Deckschicht sind Fluoropolymere wie Copolymere von Ethylen and Tetrafluoroethylen, wie es beispielsweise von DuPont Corporation unter dem Handelsnamen Tefzel® vertrieben wird oder ein Polyvinylidenfluorid, vertrieben von der DuPont Corporation unter dem Handelsnamen Tedlar®.

Bei der Trägerschicht 5 kann es sich beispielsweise um ein Stahlblech, eine PET Folie oder eine Polyimid-Folie handeln.

Es ist weiterhin vorteilhaft, wenn die Membran einen seitlichen Abschluss 8 aufweist. Der seitliche Abschluss soll die an der seitlichen Aussenseite der Membran 1 befindlichen Kontaktstellen der Solarzelle 4 mit der Ausgleichsschicht 3 vor Feuchtigkeit und konsequenterweise vor Delamination und Versagen schützen. Dies in insbesondere dann vorteilhaft, wenn sich aufgrund von Spannungen Hohlräume an den Kontaktflächen von Ausgleichsschicht 3 und Schottschicht 2, respektive Solarzelle 4, gebildet haben.

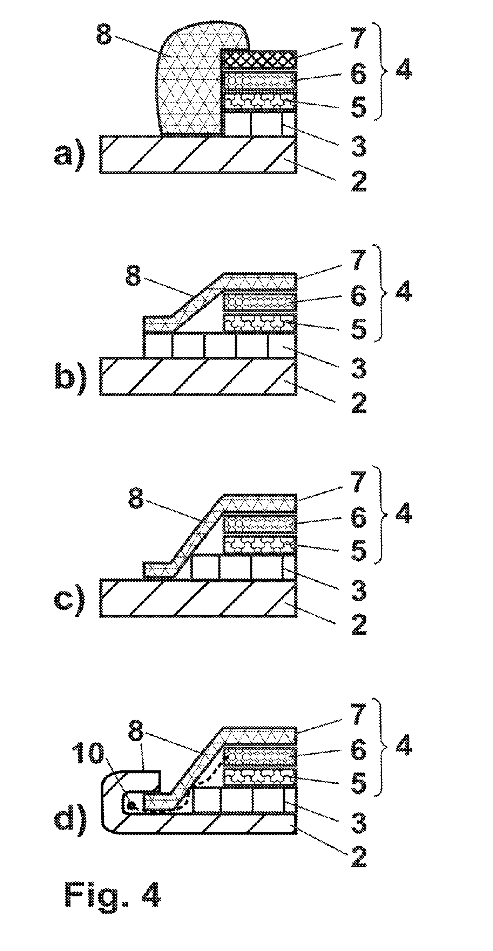

Bei dem seitlichen Abschluss kann es sich um einen Kunststoff handeln, welcher mit der Solarzelle, der Ausgleichsschicht und der Schottschicht in Kontakt ist, wie dies in Figur 4a dargestellt ist. Vorzugsweise steht die Schottschicht 2 gegenüber der Solarzelle 4 und der Ausgleichsschicht 3 seitlich über, typischerweise um jeweils bis zu 10 mm, wodurch eine bessere Dichtleistung des seitlichen Abschluss erzielt wird.

Bei dem seitlichen Abschluss kann es sich auch um die Deckschicht 7 handeln, welche seitlich über die Photovoltaikschicht 6, resp. über die Trägerschicht 5 ragt und mit der Ausgleichsschicht 3 verbunden ist, wie dies beispielsweise in Figur 4b gezeigt ist. Ist die gesamte Ausgleichsschicht seitlich durch die Trägerschicht vor Feuchtigkeit geschützt, ist dies zusätzlich dem Verbund der Ausgleichsschicht mit der Schottschicht zuträglich. Dies ist in Figur 4c gezeigt.

Bei einem solchen seitlichen Abschluss kann die Deckschicht 7 auch seitlich über die Photovoltaikschicht 6, resp. über die Trägerschicht 5 und über die Ausgleichsschicht 3 ragen und mit der Schottschicht 2 verbunden sein. Der Verbund geschieht typischerweise durch Verkleben oder Verschweissen, insbesondere Verschweissen. Figur 4d zeigt eine solche Ausführungsform.

Die Dichtwirkung der letztgenannten Möglichkeit eines seitlichen Abschlusses kann weiter verbessert werden, indem die Schottschicht die Deckschicht seitlich umschliesst und einen Börtelfalz bildet. Ein weiterer Vorteil einer solchen Lösung wäre, dass eventuell vorhandene Mittel zum elektrischen Anschluss 10 der Fotovoltaikschicht in dem Börtelfalz vor Feuchtigkeit geschützt angeordnet werden können. Dies ist insbesondere für Mittel zum elektrischen Anschluss 10 vorteilhaft.

Die Membran 1 kann auf jede Art und Weise hergestellt werden. Insbesondere können die Membranen auf handelsüblichen Maschinen hergestellt werden. Die Membranen können in einem einzigen Verfahrensschritt als Endlosware, beispielsweise durch Extrusion und/oder Kalandrieren und/oder Kaschieren, hergestellt werden und beispielsweise auf Rollen aufgerollt werden. Die Massetemperatur im Extruder oder Kalander kann in einem Bereich von 100°C - 210°C, bevorzugt 130°C - 200°C insbesondere 170°C - 200°C, liegen, bevorzugt während der Extrusion und/oder dem Kalandrieren und/oder dem Kaschieren.

Die Ausgleichsschicht 3 kann während der Herstellung durch Breitschitzdüsenextrusion, durch Schmelzkalandrieren, durch Bandpressen mittels IR-Bestrahlung, durch Flammkaschierung oder Sprühkaschierung aufgetragen werden. Es ist vorteilhaft, dass die Ausgleichsschicht eine Zusammensetzung und eine Standfestigkeit aufweist, die mit den Temperaturen der Herstellung der Membran 1 verträglich ist.

Vorzugsweise wird die Ausgleichsschicht 3 durch Kaschieren mit der Schottschicht 2 verbunden, insbesondere bevorzugt ist das Kaschieren durch Bandpressen mittels IR-Bestrahlung. Der Verbund mit der Schottschicht kann jedoch auch, wie vorgehend erwähnt, durch Klebstoffe geschehen. Weiter kann eine Vorbehandlung der Schottschicht, wie vorhergehend erwähnt, beispielsweise durch Beflammung und Coronabehandlung vorteilhaft sein.

Der Verbund der Ausgleichsschicht 3 mit der Solarzelle 4, respektive mit der Trägerschicht 5 der Solarzelle, erfolgt typischerweise durch Kaschieren, insbesondere Flammkaschieren, der Verbund kann jedoch auch, wie vorgehend erwähnt, durch Klebstoffe geschehen.

In einer bevorzugten Ausführungsform der Herstellung der Membran 1 werden die Solarzelle 4, respektive mit der Trägerschicht 5 der Solarzelle und die Schottschicht 2 durch Kaschieren mit der Ausgleichsschicht 3 verbunden. Ferner wird die Deckschicht 7 durch Verschweissen mit der seitlich überstehenden Schottschicht verbunden. Vorzugsweise wird die Schottschicht zusätzlich, wie vorgehend beschrieben, um das äussere Ende der Deckschicht gebörtelt und verschweisst.

Selbstverständlich ist die Erfindung nicht auf die gezeigten und beschriebenen Ausführungsbeispiele beschränkt.

### Bezugszeichenliste

- 1: Membran
- 2: Schottschicht
- 3: Ausgleichsschicht
- 4: Solarzelle
- 5: Trägerschicht
- 6: Photovoltaikschicht
- 7: Deckschicht
- 8: Seitliche Abdichtung
- 9: Klebschicht
- 10: Mittel zum elektrischen Anschluss

## Patentansprüche

1. Membran (1) umfassend:
eine Schottschicht (2),
eine Solarzelle (4), angeordnet an einer Seite der Schottschicht (2),
sowie eine Ausgleichsschicht (3), angeordnet zwischen Solarzelle (4) und Schottschicht (2), wobei es sich bei der Ausgleichsschicht (3) um eine geschäumte Zusammensetzung aus einem bei Raumtemperatur festen Thermoplast oder einem bei Raumtemperatur festen thermoplastischen Elastomer handelt.

2. Membran (1) gemäss Anspruch 1, **dadurch gekennzeichnet, dass** es sich bei der Ausgleichsschicht (3) um eine geschlossenporige geschäumte Zusammensetzung handelt.

3. Membran (1) gemäss einem der vorhergehenden Ansprüche, **dadurch gekennzeichnet, dass** es sich bei der Ausgleichsschicht (3) um eine geschäumte Zusammensetzung mit einer Porengrösse von 0.1 - 3 mm, insbesondere 0.2 - 1 mm und/oder einem Porenvolumen von 5 - 99%, insbesondere 30 - 98%, handelt.

4. Membran (1) gemäss einem der vorhergehenden Ansprüche, **dadurch gekennzeichnet, dass** die Ausgleichsschicht (3) eine Dichte von 0.02 - 1.2 g/cm³, bevorzugt 0.03 - 0.8 g/cm³, insbesondere bevorzugt 0.05 - 0.5 g/cm³ aufweist.

5. Membran (1) gemäss einem der vorhergehenden Ansprüche, **dadurch gekennzeichnet, dass** es sich bei der Ausgleichsschicht (3) um eine geschäumte Zusammensetzung aus einem Material, welches ausgewählt ist aus der Gruppe bestehend aus Acrylatverbindungen, Acrylatcopolymeren, Polyurethanpolymeren, Silan-terminierten Polymeren und Polyolefinen, insbesondere aus Polyolefinen, handelt.

6. Membran (1) gemäss einem der vorhergehenden Ansprüche, **dadurch gekennzeichnet, dass** die Ausgleichsschicht (3) direkt mit der Schottschicht (2) verbunden ist.

7. Membran (1) gemäss einem der Ansprüche 1 - 5, **dadurch gekennzeichnet, dass** die Ausgleichsschicht (3) und die Schottschicht (2) durch eine Klebschicht (9) miteinander verbunden sind.

8. Membran (1) gemäss Anspruch 7, **dadurch gekennzeichnet, dass** die Klebschicht (9) einen Haftklebstoff und/oder ein Schmelzklebstoff umfasst.

9. Membran (1) gemäss Anspruch 8, **dadurch gekennzeichnet, dass** die Klebschicht (9) einen Klebstoff umfasst, welcher ausgewählt ist aus der Gruppe bestehend aus Ethylen/Vinylacetat-Copolymer (EVA), vernetzbare thermoplastische Elastomere auf Olefinbasis, Acrylatverbindungen, Polyurethanpolymeren und Silan-terminierten Polymeren.

10. Membran (1) gemäss einem der vorhergehenden Ansprüche, **dadurch gekennzeichnet, dass** die Schottschicht (2) eine Thermoplastschicht, vorzugsweise eine Schicht aus thermoplastischen Polyolefinen oder Polyvinylchlorid (PVC), insbesondere eine Schicht aus Polypropylen (PP) oder Polyethylen (PE), aufweist.

11. Membran (1) gemäss einem der vorhergehenden Ansprüche, **dadurch gekennzeichnet, dass** die Schottschicht (2) eine Dicke von 0.05 - 3 mm, bevorzugt 0.08 - 2.5 mm, insbesondere 1 - 2 mm, aufweist.

12. Membran (1) gemäss einem der vorhergehenden Ansprüche, **dadurch gekennzeichnet, dass** die Membran einen seitlichen Abschluss (8) aufweist.
